# EUROPEAN PATENT APPLICATION

(11) **EP 2 599 626 A1**
(43) Date of publication of application: **05.06.2013**
(21) Application number: 11191155.8
(22) Date of filing: 29.11.2011
(51) Int. Cl.: B32B 27/32, H01L 31/048

(54) **Solar modules containing a backsheet with a polyolefin bonding layer**

(71) Applicant: 3M Innovative Properties Company, Saint Paul, MN 55133-3427 (US)
(72) Inventor: Juergens, Michael, 41199 Mönchengladbach (DE); Schoeppel, Wolfgang, 41470 Neuss (DE); Stollwerck, Gunther, 47802 Krefeld (DE); Graichen, Andreas, 40721 Hilden (DE)
(74) Representative: Kurz, Arnd

(57) **Abstract**

Method for making a solar module (1) comprising in order of position from the front, i.e. the light-receiving side, to the back:
(a) a top part (40) comprising a top layer (11) and a solar cell layer (12) containing at least one encapsulant (121) and solar cells (122) on an aluminium-containing carrier (124) and
(b) a bottom part (41) comprising a multi-layer backsheet (13) contacting at least the aluminium containing carrier (124) of the solar cell layer (12), said method comprising
i) providing a multi-layered backsheet (13) having at least one bonding layer (14) forming the top surface (131) and at least one layer forming the rear surface (111) opposite to the top surface (131) of the backsheet (13) and wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof;
ii) laminating the backsheet with its bonding layer (14) to the carrier (124) of the solar cells (222) of the solar cell layer (12).

Also provided are solar modules containing the backsheets described above and support structures containing the solar modules described above

## Description

### Field

This disclosure relates to multi-layered backsheets containing a polyolefin bonding layer and to methods for making solar modules by using the backsheets and to methods of mounting solar modules to support structures by using the backsheets.

### Background

The use of solar modules has rapidly increased due to a greater demand in renewable energies. The current solar cells can typically be classified into wafer-based solar modules (also referred to as crystalline solar cells or modules) and thin film solar modules. Wafer-based solar modules typically contain crystalline silicon, for example monocrystalline silicon (c-Si), poly- or multi-crystalline silicon (poly-Si or mc-Si). The wafers are generally about 180 and about 240 µm thick and are typically deposited on a support structure, the so-called solar cells. Several solar cells are typically electrically connected to each other and are arranged into a plane and form the so-called solar cell layer of a photovoltaic module. The solar cell layer is generally embedded in encapsulant material and protected by its top side, the light-receiving side by a cover sheet of light-transmitting material and on its rear side by a so-called backsheet. In general, a solar cell module comprises, in order of position from the front, i.e. the light-receiving side, to the rear side, i.e. the side opposite to the light-receiving side: a top layer, an encapsulated solar cell layer and a backing layer. Typical commercial materials for backing layers, also referred to as backsheets, are multi-layered articles containing an electrically insulating polyester layer and/or a weather-resistance fluoropolymer layer. They may additionally contain a top layer, like an EVA layer, for providing good adhesion to the encapsulant. Other commercial materials employ polyamides or other polymers.

The modules usually contain perimeter frames made of aluminium to further protect the brittle modules and for mounting the solar modules onto a surface or structure to which they are installed to generate electricity, for example rails or roofs.

The solar industry is very competitive due to the steeply increased demand on renewable energies and is under pressure to reduce costs. Therefore, there is a continued need for economical solutions.

### Summary

In one aspect there is provided a method for making a solar module (1) comprising in order of position from the front, i.e. the light-receiving side, to the back:
(a) a top part (40) comprising a top layer (11) and a solar cell layer (12) containing at least one encapsulant (121) and solar cells (122) on an aluminium-containing carrier (124) and
(b) a bottom part (41) comprising a multi-layer backsheet (13) contacting at least the aluminium containing carrier (124) of the solar cell layer (12),
said method comprising
i) providing a multi-layered backsheet (13) having at least one bonding layer (14) forming the top surface (131) and at least one layer forming the rear surface (111) of the backsheet (13) that is opposite to the top surface (131) and is exposed to the outside of the solar module, and wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof;
ii) laminating the backsheet with its bonding layer (14) to the carrier (124) of the solar cells (222) of the solar cell layer (12).

In another aspect there is provided an aluminium containing support structure (2) for solar modules comprising a solar module (1) as defined herein laminated to the support structure (2) by at least a part of the rear surface (111) of the backsheet (13).

In a further aspect there is provided a solar module (1) comprising in order of position from the front, i.e. the light-receiving side, to the back:
(a) a top part (40) comprising a top layer (11) and a solar cell layer (12) containing at least one encapsulant (121) and solar cells (122) on an aluminium-containing carrier (124) and
(b) a bottom part (41) comprising a multi-layer backsheet (13) having a bonding layer (14) forming the top surface (131) of the backsheet (13) and contacting at least the aluminium containing carrier (124) of the solar cells (122) of the solar cell layer (12), and at least one layer forming the rear surface (111) that is opposite to the top surface (131) and is exposed to the outside of the solar module, wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.

### Brief Description of the Figures

Figure 1 is a schematic cross-sectional view of a photovoltaic module.
Figure 2 A is a schematic representation of a solar module mounted on a support structure and fixed on a pole.
Figure 2 B is a schematic representation of a solar module mounted on a frame and attached on the roof of a building.
Figure 2 C is a schematic cross-sectional view of a photovoltaic module mounted on a support frame by means of adhesives according to the prior art.
Figure 3 is a schematic cross-sectional representation of a solar module comprising a backsheet according to the present disclosure.
Figure 4 is a schematic cross-sectional representation of a backsheet according to the present disclosure.
Figure 5 is a schematic cross-sectional representation of a backsheet according to the present disclosure. Figure 6 is a schematic cross-sectional representation of a solar module containing a backsheet according to the present disclosure that can be wrapped around the edges of the top part of the solar module.
Figure 7 is a schematic representation of a multi-layer backsheet according to the present disclosure mounted on backrails.
Figure 8 is a schematic representation of a multi-layer backsheet according to the present disclosure mounted on a frame.

### Detailed Description

Before any embodiments of this disclosure are explained in detail, it is to be understood that the disclosure is not limited in its application to the details of construction and the arrangement of components set forth in the following description. The invention is capable of other embodiments and of being practiced or of being carried out in various ways. Also, it is to be understood that the phraseology and terminology used herein is for the purpose of description and should not be regarded as limiting.

As used herein, the terms "comprises," "comprising," "includes," "including," "containing," "characterized by," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus and including equivalents. Further, unless expressly stated to the contrary, "or" refers to an inclusive or and not to an exclusive or.

As used herein, the term "consisting of" is meant to be limiting and include only the specified materials or steps and their equivalents.

The use of "a" or "an" is meant to encompass "one or more".

Any numerical range recited herein is intended to include and to specifically disclose the end points specified and also all integers and fractions within that range. For example, a range of from 1% to 50% is intended to be an abbreviation and to expressly disclose the values 1% and 50% and also the values between 1% and 50%, such as, for example, 2%, 40%, 10%, 30%, 1.5 %, 3.9 % and so forth.

The term "copolymer" is used to refer to polymers containing two or more monomers.

### Solar modules:

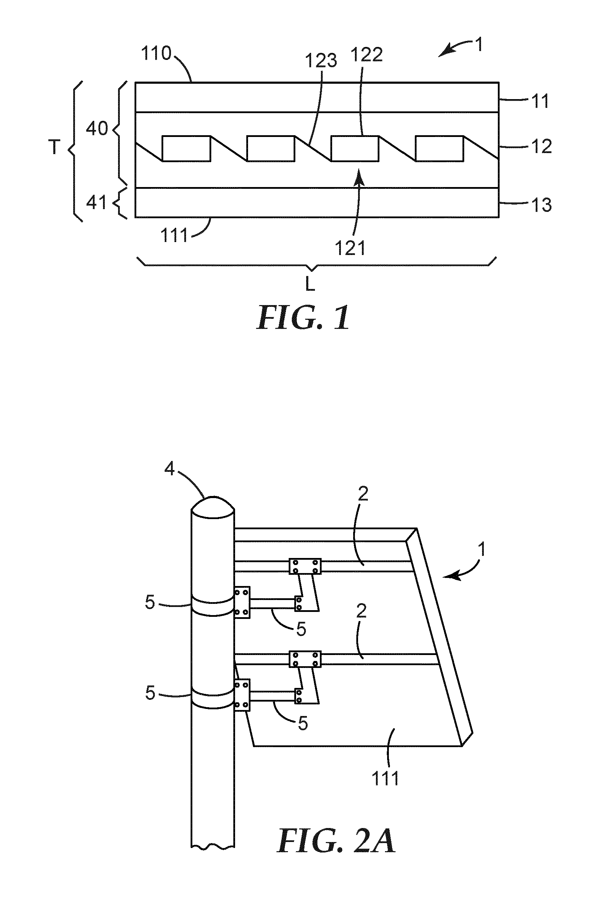

A typical solar module is shown in figure 1, to which is now referred: a solar module (1) typically comprises a front side (110) and a rear side (111). The front side (110) is the external light-receiving side and is a major side of the solar module. The rear side (111) is another major external side of the solar module and is opposite to the front side (110).

The solar module contains along its thickness (T) (or edge), i.e., in order of position from the front side (110) to the rear side (111)): a top layer (11), a solar cell layer (12) and a backing layer (13). The top layer (11) and the solar layer (12), including optional layers between them, make up the top part (40) of the solar module (1). The bottom part (41) comprises the backing layer (13).

The top layer (11) typically serves as the outermost layer(s) of the module at the light-receiving side. The outermost layer may be formed of any suitable transparent sheets or films. Suitable sheets may be glass or plastic sheets, such as polycarbonates, acrylic polymers (i.e., thermoplastic polymers or copolymers of acrylic acid, methacrylic acid, esters of these acids, or acrylonitrile), polyacrylates, cyclic polyolefins (e.g., ethylene norbornene polymers), polystyrenes (preferably metallocene-catalyzed polystyrenes), polyamides, polyesters, fluoropolymers, or combinations of two or more thereof. Typically, the outmost layers are made of glass. The term "glass" includes not only window glass, plate glass, silicate glass, sheet glass, low iron glass, tempered glass, tempered CeO-free glass, and float glass, but also colored glass, specialty glass (such as those types of glass containing ingredients to control solar heating), coated glass (such as those sputtered with metals (e.g., silver or indium tin oxide) for solar control purposes), E-glass, Toroglass, SOLEX glass (PPG Industries, Pittsburgh, Pa, USA.) and STARPHIRE glass (PPG Industries). It is understood, however, that the type of glass to be selected for a particular module depends on the intended use. The top layer(s) may be a single layer or a multi-layer construction.

The solar cell layer (12) contains at least one solar cell (122) and at least one polymeric material (121) encapsulating fully or partially the at least one solar cell (122). Typically, the electricity generated by a single solar cell is too low and solar modules typically contain a series of a plurality of solar cells. The solar cells are electrically interconnected (typically in series). Generally they are arranged in a flat plane. Therefore, the solar cell layer (12) also contains electrical wirings (123) connecting the solar cells and connecting them to the outside of the module, such as cross ribbons and bus bars which collect the electricity generated by the solar cells and transport them to an electrical contact at the outside of the solar module.

The solar cells contain the semiconductors which generate electricity from the incident light. Various types of semiconductors may be used in solar cells. Examples include monocrystalline silicon (c-Si solar sells), polycrystalline silicon (p-Si or mc-Si solar cells) and amorphous silicon (a-Si solar cells). Other solar cells include GaAS solar cells, CdTe solar cells, CIS or CIGS solar cells which contain copper-indium-selenide or sulfide or copper-indium-gallium selenide or sulfide. The latter are predominantly used on so called thin-film solar modules, which are thinner than solar modules using crystalline silicons. The semiconductors may be deposited on a supporting structure, typically an aluminum containing carrier, like an aluminum sheet or an aluminum paste applied on a carrier. A conductive grid is placed on the light-receiving surface of the solar cell. The grid typically contain a plurality parallel lines. These lines are typically coated or screen printed onto the semiconductors. The lines generally contain a conductive ink. The lines feed into conductive strips, also called "fingers" , which collect the charge and transport the current generated by the cells away by collecting wires. Preferred solar cells are wafer-based solar cells (e.g., c-Si or mc-Si based solar cells), typically deposited on a carrier, like for example an aluminium carrier.

The interconnected solar cells in photovoltaic modules are generally at least partially embedded in one or more encapsulants (121). Therefore, the solar cell layer (12) also contains one or more encapsulant layers. The solar cell layer (12) may be completely encapsulated, which means the light-receiving side of the solar cells and the rear side (i.e. the side opposite to the light-receiving side), or more specifically the side of the support structure opposite to the side of the support structure onto which the semiconductors have been deposited, is covered by one or more encapsulants (121). The encapsulants (121) may comprise any suitable polymeric material. Such materials melt or flow under the lamination conditions (i.e. the temperature and pressure applied to laminate the encapsulant material (121) onto the solar cells and their support structure) and undergo curing, i.e. cross-linking. Some specific examples of such polymeric materials include acid copolymers (i.e. copolymers of an olefin and an unsaturated carboxylic acid or acid anhydride), poly(ethylene vinyl acetates), poly(vinyl acetals), polyurethanes, poly(vinyl chlorides), copolymers of an α-olefin and an α,β-ethylenically unsaturated carboxylic acid ester (e.g., ethylene methyl acrylate copolymer and ethylene butyl acrylate copolymer), silicone elastomers, epoxy resins, and combinations of two or more thereof. Preferably, the encapsulant (121) comprises poly(ethylene vinyl acetates) (EVA), i.e. a copolymer comprising repeating units derived from ethene and vinyl acetate. Thus, the solar cell layer (12) has a light-receiving side (the front side or the side facing the top layer (11)) and a rear side opposite thereto, facing the backing layer (13). A fully encapsulated solar cell layer (12) is covered by its front and rear sides by encapsulant (121). In partially encapsulated solar cell layers (12) only one of these sides, typically the front side of the solar cell layer is covered by an encapsulant (121). The rear surface at the carriers of the semiconductors may then be uncovered or substantially uncovered, for example, at least 50% of its surface is not covered by encapsulant.

The solar modules contain at their rear side a backing layer. The backing layer protects the solar module from environmental deterioration and provides electrical insulation.Typical commercial backing layers, also referred to as backsheets, are multi-layered articles containing an electrically insulating polyester or polyamide layer as an internal layer, and a weather-resistant fluoropolymer layer as an external layer. An EVA layer is typically used to facilitate the adhesion of the polyester or polyamide layer to the encapsulant material of the solar cell layer. The solar modules provided herein contain a backsheet with at least one polyolefin-based bonding layer as will be described in greater detail below.

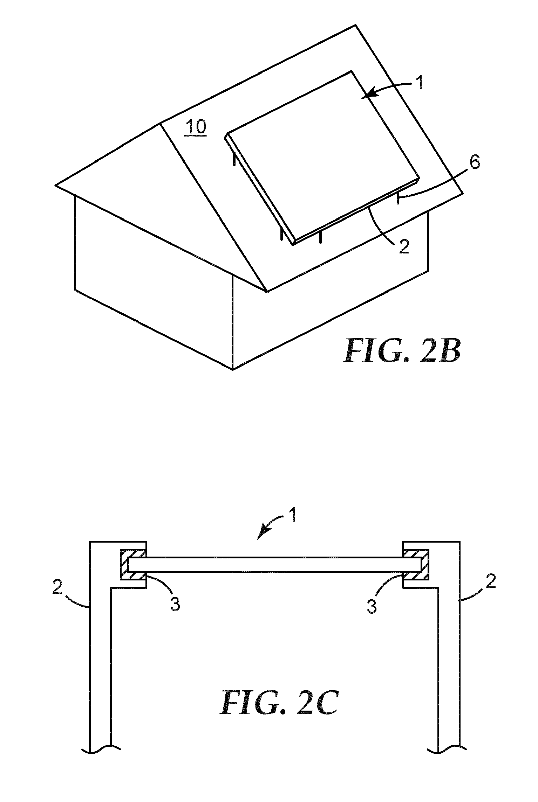

Photovoltaic modules are typically mounted onto frames or other support structures and are then installed to their final attachment, for example poles or rails of solar power stations or on roofs of buildings. Figure 2A shows a solar module (1) mounted on a support (2) by its rear surface which is attached to a pole (4) by mechanical fastening means (5). Figure 2C shows a solar module mounted on a frame (2) that has been installed on carriers (6) and has been attached to the roof (10) of a building.

Support structures for solar modules, like for example frames, typically contain an area appropriately shaped for receiving the edges and/or the back of a solar module. An example of a frame for receiving an edge of a solar module is shown in figure 2C to which will now be referred. The frame (2) has parts (21) shaped for receiving the solar module (1). Such parts (21) may be, for example, a recess or a bracket. Typically, the parts (21) for receiving the solar module are slightly deeper and/or wider than the edges of the solar module which they are to hold. The solar modules of the prior art are typically held in place by use of adhesives like liquid adhesives or adhesive tapes (3).

The backsheets according to the present disclosure are multi-layer materials comprising at least one polyolefin sheet. The polyolefin sheet allows the backsheets to be directly bonded to an aluminium containing surface, for example by lamination. This can save costs on adhesive materials and may also simplify the assembly of solar modules. Lamination is achieved by adhering two substrates together by using a heat treatment. The heat treatment may be carried out at increased or reduced pressure (like e.g. vacuum lamination). Because of its purpose the polyolefin sheet is referred to herein as "bonding layer". Backsheets containing the exposed polyolefin sheets may be sufficient to provide the mechanical stability, weathering (yellowing) resistance and/or electrical insulation required for backsheets in solar modules. Surprisingly, the multi-layer backsheets disclosed herein can be more resistant to exposure to humid heat than multi-layered materials containing no polyolefin sheets.

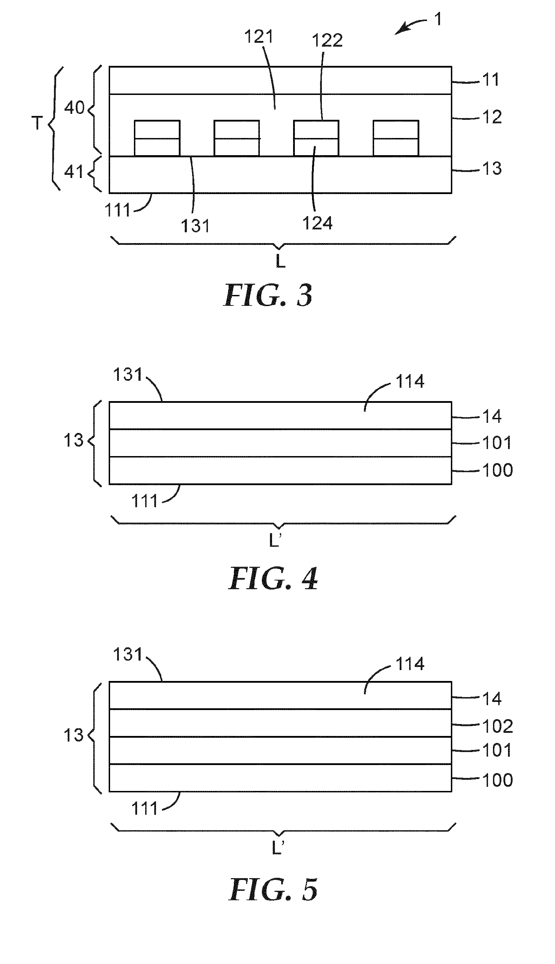

The backsheets and the solar modules containing them will now be described in greater detail by referring to figures 3 to 8 to further illustrate the disclosure. Figure 3 shows a schematic representation of a solar module containing a backsheet according to the present disclosure. The solar module (1) may be of angular shape. It may, for example have angular major external surfaces, for example, when viewed from top, in the shape of a rectangle, a square or a polygon and has a length (L) and a width. In case of circular structures the length and width may be replaced by diameters. The major external surfaces of the solar modules typically are the light receiving side and the rear side on the other (opposite) end of the solar module.
The solar module also has a thickness, orthogonal to the plane made up by the length and width of the solar module. The (minor) external surfaces of the solar module along the thickness and typically orthogonal to the plane defined by the length and width of the solar module form the edges of the solar module.

The solar module (1) contains (from the top (i.e. the light receiving side along a direction parallel to the thickness (T) (or the edge of the solar module), a top part (40) comprising a top layer (11) and a solar cell layer (12). The solar cell layer contains solar cells (122) on a aluminium containing carrier (124). The solar cells are partially encapsulated by encapsulant (121) leaving the carriers (124) at least partially exposed for contacting (lamination to) the top surface (131) of the backsheet (13) making up the bottom part (41) of the module (1). The backsheet (13) contains a rear surface (111) which is opposite to the top surface (131) and is exposed to the outside of the solar module. The backsheet (13) shown in figure 3 has the same length as the top part (40) of the solar module (1).

Figures 4 and 5 are schematic representations of the backsheet shown in figure 3.

The backsheet (13) according to the present disclosure is a multi-layer article comprising at its top surface (131) the bonding layer (14). The bonding layer (14) forms at least a part of the top surface (131) of the backsheet (13). Preferably, it forms the entire top surface (131). In the embodiment shown in figure 4, the bonding layer (14) forms the (entire) top surface (131) of the backsheet (13). The back layer (100) forms the rear surface (111) of the backsheet (13). Preferably it also forms the rear side of the solar module (1), more specifically, the external side of the solar module that is opposite to the light-receiving side. Back layer (100) and bonding layer (14) may be separated by intermediate layer (102) or a plurality thereof.

The light receiving side (top surface) and the opposite side (rear surface) are the two major sides of the solar module. The bonding layer (14) of the backsheet (13) contains the polyolefin-based sheet (114). The polyolefin-sheet (114) allows for the good lamination of the backsheet to aluminium containing carrier (124) shown in figure 3.

The backsheet (13) contacts via its top surface (131) and bonding layer (14) the solar cell layer (12) and more particularly the aluminium containing carrier (124). The solar cell layer typically contains as an encapsulant (121) a material containing EVA or silicones. Therefore, the backsheet (13) is typically attached (laminated) by its top surface (131) to the aluminium containing carrier and the encapsulant material (121) of the solar cell layer (12) as shown in figure 3.

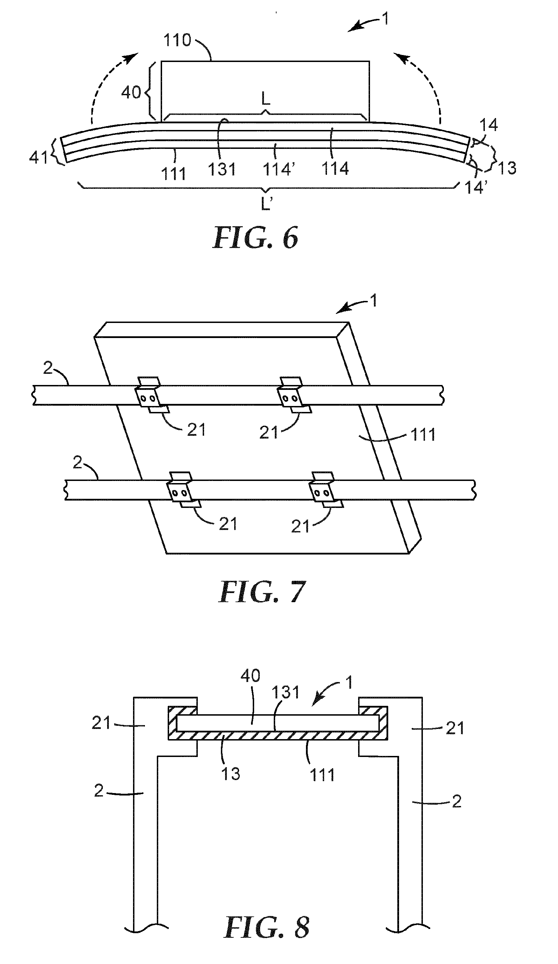

The solar modules (1) according to the present disclosure may be attached (laminated) to an aluminium containing support structure (2) when the back layer (100) is a further bonding layer (100) containing a polyolefin sheet (114). The further bonding layer (100) preferably forms the entire rear side (111) of the backsheet (13) and the solar module (1) may be attached by its rear surface (111) to aluminium support structures (2), like for example backrails. In such embodiments, the backsheet (13), may have the same length (L') and/or width (W') as the length (L) and/or width (W) of the top part (40) of the solar module (1) or it may have a smaller length and/or width than the top part of the solar module. In one embodiment, the backsheet is laminated by at least a section of its rear side (111) to an aluminium containing support structure (2), for example a backrail or a component (21) of a backrail (2) as shown in figure 7.

In another embodiment of the present disclosure, the backsheet (13), or at least the further bonding layer (100), may be dimensioned such that it can be wrapped around at least one or more than one or all edges of the top part (40) of the solar module (1). This means the backsheet (13), or at least its bonding layer (100), is of greater length (L') and/or width (W') than the length (L) top part (40) of the solar module (1). Such an embodiment is shown in figure 6, in which the further bonding layer (100) is denoted as (14'). Solar modules containing backsheets according to this embodiment may be suitably attached to frames for solar modules, like perimeter frames, which contain an area shaped to receive at least one edge of the solar module such as appropriately dimensioned brackets or recesses. In this embodiment it is not required that the bonding layer (14') forms the entire rear surface (111) of the backsheet (13). It may be sufficient that the ends of the further bonding layer (14') can be wrapped around the edge(s) of the top part (40) of the solar module (1) and are sufficiently exposed to the outside such that they provide an area for contacting the support structure. The remainder of the rear surface of the backsheet may be made up by a different material or sheet. It is understood that the bonding layer (100) or (14') of the backsheet (13) of such embodiments do not cover the entire light-receiving surface of the top part (40) of the solar module (1) when they are wrapped around the edges of the top part because otherwise the light and energy efficiency of the solar module would suffer.

Figure 8 shows a solar module (1) according to the present disclosure having a top part (40) and a back part (41) containing a back sheet (13) according to the present disclosure wrapped around the edges of the top part (40) of the solar module (1) and mounted on an aluminium containing frame (2). The frame is shaped (21) to receive the solar module (1) and the solar module (1) is laminated to the frame by a bond between the backsheet (13) and the aluminium surface of the frame (2). The bond is created by a heat treatment as described below, for example lamination.

The backsheet (13) according to the present disclosure provides electrical insulation. Typically, the backsheet has a dielectric breakdown voltage of at least 10 kV or at least 20 kV. The break down voltage can be determined according to ASTM D 149.

The backsheets may also provide mechanical protection of the solar module. Typically, the backsheets have an elongation at break of at least 50% and a tensile strength of at least 15 MPa. The mechanical properties can be determined according to ASTM D 882.

The backsheet (13) typically has a total thickness of from about 0.22 mm (or 0.250 mm) to about 0.80 mm or from about 0.35 mm to about 0.70 mm, or from about 0.40 mm to about 0.65 mm. A greater thickness is not harmful but adds to the costs of the material.

The backsheets (13) may be surface treated. The top and/or rear surface of the backsheets (13) may be surface treated. Surface treatment may be carried out to improve the compatibility or adhesion to another surface or to provide a functional or decorative pattern or structure. For example, the backsheets (13) may have smooth or rough surfaces on one or both of its major external sides (131, 111). Rough surfaces may facilitate deaeration during the lamination process when the backsheet is included in a solar cell module. Rough surfaces can be created by mechanical embossing or by melt fracture during extrusion of the sheets followed by quenching so that surface roughness is retained during handling.

A typical example for surface treatment to improve adhesion to other substrates, such as for example, external components like junction boxes, or mounting materials, involves a plasma treatment, like a corona treatment. Corona treatments may be carried out for example under air or nitrogen atmosphere or other suitable atmospheres. The backsheets are preferably subjected to a corona treatment because this may also increase the adhesion of the polyolefin layer to aluminium. Corona treatment (plasma treatment) is a surface modification technique that uses a plasma to impart changes in the properties of a surface. The corona plasma is generated by the application of high voltage to sharp electrode tips which forms plasma at the ends of the sharp tips. A linear array of electrodes is often used to create a curtain of corona plasma. The material may be passed through the corona plasma curtain in order to change the surface energy of the material.

In one preferred embodiment of the present disclosure the backsheet (13) is not transparent. Such backsheets (13) are typically coloured. They may contain dyes or pigments or may be painted i.e. they contain a coloured coating. Preferably the backsheets (13) contain white pigments as described below or they contain carbon particles as described below.

The backsheet (13) may contain patterns displaying information on its surface (rear and/or top surface). Such patterns may be symbols, numbers or letters or a plurality or combination thereof. Preferably the polyolefin-based sheet (114) contains such patterns because they can be easily provided on polyolefin-based materials. Patterns displaying information may be laminated onto the polyolefin-based sheets (114) or introduced into them by stamping. Such information may be, for example, a logo or instructions.

The backsheet (13) contains at least one bonding layer (14) and preferably a further bonding layer (100). The bonding layers (14) or (100) of the backsheet (13) provides one or more external surfaces of the backsheet that can be exposed to aluminium-containing surfaces (such as support structures (2) for holding solar modules or carriers (124) for solar cells) for adhesion (lamination) of the backsheet to that surface. Such external surface of the bonding layer(s) may be created in various ways, for example by the further bonding layer (100) forming the entire rear side of the solar module or only a part of the rear side, for example by forming foldable ends extending beyond the length or width of the top part of the module. The bonding layer (14) may form part of the top surface (131) and preferably forms the entire top surface (131) of the backsheet (13). The bonding layer (14) and back layer (100) are preferably the outmost layers of the backsheet. In case of layer (100) it may also be the outmost rear layer of the solar module exposed to the outside.

The further bonding layer (100) may contain carbon particles. The bonding layer (14) may contain pigments, for example white pigments as described below instead of carbon particles. The further bonding layer (100) may contain from about 1% to about 6% or up to about 10% weight based on the weight of the layer of carbon particles. The loading with carbon particles may be increased but in that case the layer may become electron conductive. In this case the layer may have to be earthed when it is incorporated into a solar module. Typically, the further bonding layer (100) is not transparent and may be of black colour due the presence of carbon particles. However, the layer can be of a different colour if pigments or paints are used.

In addition or as alternative to the carbon particles layer (100) may contain other additives. In addition or as alternative to the pigments, bonding layer (14) may contain other additives. Such additives include antioxidants, for example those described below. Other additives include UV-absorbers, for example those described below, cross-linkers as described below and flame retardants, like those described below and anti dripping agents. The amount of these ingredients may be individually or combined be from about 1%wt to up to 10% wt based on the total weight of the layer. The types and amounts of additives depend on the construction of the bonding layer and/or backing layer (13) in particular its dimensions. Such additives will be described in greater detail below.

Typically, the bonding layer (14) and the further bonding layer (100) may have, independently from each other, a thickness of about 50 to about 550 µm. Typically, the bonding layer (14) and further bonding layer (100) may have, independently from each other, a thickness of at least 205 µm or at least 305 µm. Typically the layer (14) and/or (100) may have a thickness of less than 950 µm.

The bonding layer (14) and/or further bonding layer (100) may contain, for example, up to about 10 wt %, preferably up to about 5 wt %, and more preferably up to about 1 wt % of anitoxidants based on the total weight of the layer (14) or (100), respectively. In addition or instead of antioxidants the bonding layer (14) or (100) may contain, for example, up to about 10 wt %, preferably up to about 5 wt %, and more preferably up to about 1 wt % of UV-stabilizers based on the total weight of the layer (14) or (100), respectively.
In addition or instead of antioxidants and/or UV-stabilizers the bonding layer (14) or (100) may contain anti-dripping agents like those described below. Typical amounts include up to 1% wt, or up to 5%wt or up to 10% wt based on the weight of the layer (14) or (100) respectively.
In addition to or instead of UV stabilizers, the bonding layer (14) or (100) may contain pigments selected from zink oxide and/or titanium dioxide. Typical amounts include up to 10% by weight based on the weight of the layer (14) or (100), respectively.

The bonding layer (14) and (100) comprise independently from each other a polyolefin sheet (114) respectively.

### Polyolefin sheet:

A polyolefin sheet (114) according to the present disclosure contains cross-linked polyethene (PE) or polypropene (PP) polymers. The PE and/or PP polymers are preferably present in an amount of greater than 50% by weight or even greater than 75% by weight or even greater than 90% by weight. The weight percentages are based on the weight of the sheet (114).

Polyethene polymers (PE's) include homo- and copolymers of ethene, i.e. polymers comprising repeating units derived from ethene.
The PE polymers typically contain more than 50% by mole, preferably more than 60% by mole or more than 80% by mole and more preferably at least 95% by mole or more than 99% by mole or 100% by mole of units derived from ethene. Suitable comonomers include alkenes, in particular α-olefins such as but not limited to propene, 1-butene, 1-hexene, 1-octene and combinations thereof. Alkenes as used herein above and below include hydrocarbons with one carbon-carbon double bond and hydrocarbons with two carbon-carbon double bonds. The α-olefins may be branched or cyclic or linear. Further examples include 4-methyl-1-pentene, 1-decene, 1-dodecene, 1-tetracene, 1-hexadecene, 1-octadecene. Suitable α-olefins include in general hydrocarbons of the general formula (CₙH₂ₙ) with a terminal carbon-carbon double bond and having up to 20 carbon atoms.

Polypropene polymers (PP's) include homo- and copolymers of propene, i.e. polymers comprising repeating units derived from propene.
The PP polymers typically contain more than 50% by mole, preferably more than 60% by mole or more than 80% by mole and more preferably at least 95% by mole or more than 99% by mole or 100% by mole of units derived from propene.
Suitable comonomers include alkenes, in particular α-olefins such as but not limited to ethene, 1-butene, 1-hexene, 1-octene and combinations thereof. Alkenes as used herein above and below include hydrocarbons with one carbon-carbon double bond and hydrocarbons with two carbon-carbon double bonds. The α-olefins may be branched or cyclic or linear. Further examples include 4-methyl-1-pentene, 1-decene, 1-dodecene, 1-tetracene, 1-hexadecene, 1-octadecene. Suitable α-olefins include in general hydrocarbons of the general formula (CₙH₂ₙ) with a terminal carbon-carbon double bond and having up to 20 carbon atoms.

In one embodiment the PP polymer is selected from PP homo- or copolymers comprising more than 99% by mole of repeating units derived from propene, PP copolymers comprising at least 50% preferably at least 60%, more preferably at least 80 % and most preferably at least 95% by mole of repeating units derived from propene and one or more comonomers selected from alkenes, in particular α-olefins.

The PE and PP polymers used in the preparation of the backsheets may have a melting point (before cross-linking) of at least 100°C. The PE and PP polymers may be linear or branched. The PE and PP polymers may be blockpolymers, core-shell polymers or blends of polymers of different molecular weight distributions, or different chemical compositions or different polymer architecture. The polymers may also be grafted polymers.

Examples of suitable PE polymers include but are not limited to UHMWPE, HDPE, MDPE, LDPE, LLDPE, VLDPE. UHMWPE (ultra high molecular weight polyethene) is a polyethylene polymer with a molecular weight greater than 1 x 10⁶ g/mole, usually between 3.1 and 5.67 million g/moles. It typically has a density of 0.930-0.935 g/cm³. HDPE (high density polyethene) is a polyethylene polymer having a density of greater or equal to 0.941 g/cm³. MDPE (medium density polyethene) is a polyethylene polymer having a density range of 0.926-0.940 g/cm³. LLDPE (linear low density polyethene) is a polyethylene polymer having a density range of 0.915-0.925 g/cm³. LDPE (low density polyethene) is a polyethene polymer having a density range of 0.910-0.940 g/cm³. VLDPE (very low density polyethene) is a polyethene polymer having a density range of 0.880-0.915 g/cm³. It has been found that not only polymers of the same architecture (e.g. only branched or only linear polymers) may be used but also polymers of different structures, like, linear and non-linear polymers, may be used in the backsheets provided herein. For example one layer may be prepared by a linear material, like HDPE and another layer may be prepared by a non-linear material like LDPE.

The PE or PP polymers of the polyolefin sheet (114) are in cross-linked form in the assembled backsheet (and in the solar module) but may be used in non-cross-linked form in the preparation of the backsheet. The backing layers (13) may be prepared by non-cross-linked polymers but may be cross-linked afterwards. The cross-linking may be carried out chemically or physically, the latter being preferred. In chemical cross-linking the composition contains a cross-linker as described below. The cross-linker may be activated thermally, by chemical reaction or by irradiation, typically UV irradiation. In physical cross-linking the cross-linking is achieved by irradiating the polymers with γ- or e-beam irradiation. Preferably, the cross-linking is carried out by e-beam irradiation. The layers may be cross-linked by the same or different cross-linking methods or cross-linkers and may be subjected by sequential cross-linking. A combination of physical and chemical crosslinking may also be used. Preferably the polyolefin-based layer is cross-linked by e-beam treatment. By cross-linking the polymers form a network. This means the polymers lose their melting point, i.e. the cross-linked material does not melt at a temperature at which the polymers making up the network would melt. It either melts at a higher temperature or it does not melt at all but decomposes at a temperature greater than the melting point of the polymers used to make the network.

In a preferred embodiment the polyolefin-based sheets (114) are not cross-linked by chemical cross-linking agents or do not contain chemical cross-linking agents. The polymers according to this disclosure are preferably cross-linked by physical treatment, like, but not limited to, e-beam treatment.

Preferably, the polyethene or polypropene polymer are free or are essentially free ofolefinically unsaturated acid comonomers, like methacrylic acid or acrylic acids or copolymerizable carboxylic acid anhydrides."Essentially free" means the content of such comonomers is less than 5% by weight, or less than 1% by weight or less than 0.5 % by weight wherein the weight percentage is based on the weight of the polyethene or polypropene polymer.

In one embodiment the polyolefin sheet (114) contains the polyethene polymers described above and is free of polypropene polymers.

In another embodiment the polyolefin sheet (114) contains the polypropene polymers described above and is free of polyethene polymers.

In one embodiment the polyolefin layer (114) contains as a major component a polyethene polymer containing more than 75% by mole or more than 85% by mole or more than 95% by mole of units derived from ethene. The sheets are cross-linked, for example by physical cross-linking, like but not limited to e-beam irradiation. The dosages and/or acceleration voltages used can be optimized according to the desired performance and properties of the polyolefin-based sheet. Typical total dosages that may be applied by single or multiple treatments may be between more than 10 Mrad or more than 16 Mrad, for example 20 Mrad, 25 Mrad, 30 Mrad, 39 Mrad, 40, Mrad, 43 Mrad, 47 Mrad, 50 Mrad, 56 Mrad. Alternatively, the dosage may be less than 200 Mrad, e.g. 195 Mrad, 175, Mrad, 146 Mrad, 135 Mrad, 124 Mrad, 112 Mrad, 108 Mrad, 92 Mrad or 85 Mrad. Alternatively, the dosage may be less than 80 Mrad, e.g, 73 Mrad, 62 Mrad or 51 Mrad. Typical acceleration voltages may be between 50 and 500 kV, e.g. 70kV, 80kV, 90kV, 100kV, 110kV, 120kV, 130kV, 140kV, 150kV, 160kV, 170kV, 180kV, 190kV, 200kV, 210kV, 220kV, 230kV, 240kV, 250kV, 260kV, 270kV, 280kV, 290kV, 300kV, 310kV, 320kV, 330kV, 340kV, 350kV, 360kV, 370kV, 380kV, 390kV, 400kV, 410kV, 420kV, 430kV, 440kV, 450kV, 460kV, 470kV, 480kV, 490 kV.

The polyolefin sheets (114) of bonding layer (14) and further bonding layer (100) may be identical in their chemical composition or different. They may also be identical in their dimensions or different.

### Cross-Linker:

The polyolefin-based materials are cross-linked. Preferably the sheets are cross-linked by physical irradiation, more preferably by e-beam treatment. Less preferred are cross-linking by chemical cross-linking agents. Chemical cross-linking agents may be activated thermally or by irradiation. Typical chemical cross-linking agents include vinyl-silanes, such as but not limited to vinyl-tri-ethoxy or vinyl trimethoxy silane. They may be blended or copolymerised with the PE or PP polymers. Other types of chemical cross-linkers include radical cross-linker which decompose to generate radicals. These radicals then lead to a cross-linking reaction. Examples include but are not limited to peroxides and azo-compounds. Examples for cross-linkers activated by irradiation include but are not limited to benzophenones. Typically, the cross-linkers are dispersed in the PE or PP polymers or blended with them.

### Anti-oxidants:

Anti-oxidants can be chosen from a wide range of known anti-oxidants that are compatible with polyolefins. Examples include but are not limited to phenolic or phosphitic anti-oxidants, such as alkylated monophenols, alkylthiomethylphenols, hydroquinones, alkylated hydroquinones, tocopherols, hydroxylated thiodiphenyl ethers, alkylidenebisphenols, acylaminophenols. Other examples include but are not limited to O-, N- and S-benzyl compounds, hydroxybenzylated malonates, aromatic hydroxybenzyl compounds, triazine compounds, aminic antioxidants, aryl amines, diaryl amines, polyaryl amines, oxamides, metal deactivators, phosphites, phosphonites, benzylphosphonates, ascorbic acid (vitamin C), compounds which destroy peroxide, hydroxylamines, nitrones, benzofuranones, indolinones, and the like and mixtures thereof. More preferably, the antioxidant is a member of the class of bis-phenolic antioxidants. Suitable specific bis-phenolic antioxidants include 2,2'-ethylidenebis(4,6-di-t-butylphenol); 4,4'-butylidenebis(2-t-butyl-5-methylphenol); 2,2'-isobutylidenebis(6-t-butyl-4-methylphenol); and 2,2'-methylenebis(6-t-butyl-4-methylphenol). Some commercially available bis-phenolic antioxidants include ANOX 29, LOWINOX 22M46, LOWINOX 44B25, and LOWINOX 22IB46.

### UV-absorbers:

UV-absorbers are substances that absorb UV light and thus prevent the formation of free radicals.

Typical examples of UV absorbers include but are not limited to aliphatic or aromatic amines or polyamines, benzophenones and benzoic acid esters. Typical examples include triazines, benzotriazoles, hydroxybenzophenones, hydroxyphenyltriazines, esters of benzoic acids, and mixtures of two or more thereof. Further examples include cyclic amines. Examples include secondary, tertiary, acetylated, N-hydrocarbyloxy substituted, hydroxy substituted N-hydrocarbyloxy substituted, or other substituted cyclic amines which are further characterized by a degree of steric hindrance, generally as a result of substitution of an aliphatic group or groups on the carbon atoms adjacent to the amine function. Such compounds are commonly referred to as HALS (hindered amine light stabilizers). HALS also have anti-oxidative properties and can be used in addition or instead of anti-oxidants described above. Specific examples of HALS include, but are not limited to, 4-hydroxy-2,2,6,6-tetramethylpiperidine, 1-allyl-4-hydroxy-2,2,6,6-tetramethylpiperidine, 1-benzyl-4-hydroxy -2,2,6,6-tetramethylpiperidine, bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(1-octyloxy-2,2,6,6-tetramethyl-4-piperidyl) sebacate, bis(1,2,2,6,6-pentamethyl-4-piperidyl)n -butyl-3,5-di-tert-butyl-4-hydroxybenzylmalonate, the condensate of 1-(2-hydroxyethyl)-2,2,6,6-tetramethyl-4-hydroxypiperidine and succinic acid, linear or cyclic condensates of N,N'-bis(2,2,6,6-tetramethyl-4-piperidyl)hexamethylenediamine and 4-tert-octylamino-2,6-dichloro -1,3,5-triazine, tris(2,2,6,6-tetramethyl-4-piperidyl) nitrilotriacetate, tetrakis(2,2,6,6-tetramethyl-4-piperidyl)-1,2,3,4-butane-tetracarboxylate, 1,1'-(1,2-ethanediyl)-bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidyl)-2-n-butyl-2-(2-hydroxy-3,5-di-tert -butylbenzyl)malonate, 3-n-octyl-7,7,9,9-tetramethyl-1,3,8-triazaspiro[4,5]decan-2,4-dione, bis(1-octyloxy-2,2,6,6-tetramethylpiperidyl) sebacate, bis(1-octyloxy-2,2,6,6-tetramethyl -piperidyl) succinate, linear or cyclic condensates of N,N'-bis-(2,2,6,6-tetramethyl-4-piperidyl) -hexamethylenediamine and 4-morpholino-2,6-dichloro-1,3,5-triazine, the condensate of 2-chloro-4,6-bis(4-n-butylamino-2,2,6,6-tetramethylpiperidyl )-1,3,5-triazine and 1,2-bis(3-amino -propylamino)ethane, the condensate of 2-chloro-4,6-di-(4-n-butylamino-1,2,2,6,6-pentamethylpiperidyl)-1,3,5-triazine and 1,2-bis-(3-aminopropylamino)ethane, 8-acetyl-3-dodecyl-7,7,9,9-tetramethyl-1,3,8-triazaspiro[4,5]decane-2,4-dione, 3-dodecyl-1-(2,2,6,6-tetramethyl-4-piperidyl)pyrrolidin-2,5-dione, 3-dodecyl-1-(1,2,2,6,6-pentamethyl-4-piperidyl)pyrrolidine-2,5-dione, a mixture of 4-hexadecyloxy-and 4-stearyloxy-2,2,6,6-tetramethylpiperidine, a condensation product of N,N'-bis(2,2,6,6-tetramethyl-4-piperidyl)hexamethylenediamine and 4-cyclohexylamino-2,6-dichloro-1,3,5-triazine, a condensation product of 1,2-bis(3-aminopropylamino)ethane and 2,4,6-trichloro-1,3,5-triazine as well as 4-butylamino-2,2,6,6-tetramethylpiperidine (CAS Reg. No. [136504-96-6]); N -(2,2,6,6-tetramethyl-4-piperidyl)-n-dodecylsuccinimid, N-(1,2,2,6,6-pentamethyl-4-piperidyl)-n -dodecylsuccinimid, 2-undecyl-7,7,9,9-tetramethyl-1-oxa-3,8-diaza-4-oxo-spiro[4,5]decane, a reaction product of 7,7,9,9-tetramethyl- 2-cycloundecyl-1-oxa-3,8-diaza-4-oxospiro [4,5]decane and epichlorohydrin, 1,1-bis(1,2,2,6,6-pentamethyl-4-piperidyloxycarbonyl)-2-(4-methoxyphenyl)ethene, N,N'-bis-formyl-N,N'-bis(2,2,6,6-tetramethyl-4- piperidyl)hexamethylenediamine, diester of 4-methoxy-methylene-malonic acid with 1,2,2,6,6-pentamethyl-4-hydroxypiperidine, poly[methylpropyl-3-oxy-4-(2,2,6,6-tetramethyl-4-piperidyl)]siloxane, reaction product of maleic acid anhydride-[alpha]-olefin-copolymer with 2,2,6,6-tetramethyl4-aminopiperidine or 1,2,2,6,6-pentamethyl-4-aminopiperidine.

Examples for sterically hindered amines substituted on the N-atom by a hydroxy-substituted alkoxy group, include but are not limited to 1-(2-hydroxy-2-methylpropoxy)-4-octadecanoyloxy-2,2,6,6-tetramethylpiperidine, 1-(2-hydroxy-2-methylpropoxy)-4-hexadecanoyloxy-2,2,6,6-tetramethylpiperidine, the reaction product of 1-oxyl-4-hydroxy-2,2,6,6-tetramethylpiperidine with a carbon radical from t-amylalcohol, 1-(2-hydroxy-2-methylpropoxy)-4-hydroxy-2,2,6,6-tetramethylpiperidine, 1-(2-hydroxy-2-methylpropoxy)-4-oxo-2,2,6,6-tetramethylpiperidine, bis(1-(2-hydroxy-2-methylpropoxy)-2,2,6,6-tetramethylpiperidin-4-yl) sebacate, bis(1-(2-hydroxy-2-methylpropoxy)-2,2,6,6-tetramethylpiperidin4-yl) bis(1-(2-hydroxy-2-methylpropoxy)-2,2,6,6-tetramethylpiperidin-4-yl) succinate, bis(1-(2-hydroxy-2-methylpropoxy)-2,2,6,6-tetramethylpiperidin-4-yl) glutarate and 2,4-bis{N-[1-(2-hydroxy-2-methylpropoxy)-2,2,6,6-tetramethylpiperidin-4-yl]-N-butylamino}-6-(2-hydroxyethyl-amino)-s-triazine.

Oxamides, include, for example, 4,4'-dioctyloxyoxanilide, 2,2'-diethoxyoxanilide, 2,2'-dioctyloxy-5,5'-di-tert-butoxanilide, 2,2'-didodecyloxy-5,5'-di-tert-butoxanilide, 2-ethoxy-2'-ethyloxanilide, N,N'-bis(3-dimethylaminopropyl)oxamide, 2-ethoxy-5-tert-butyl-2'-ethoxanilide and its mixture with 2-ethoxy-2'-ethyl-5,4'-di-tert-butoxanilide, mixtures of o- and p-methoxy-disubstituted oxanilides and mixtures of o- and p-ethoxy-disubstituted oxanilides.

### Flame retardants:

Flame retardants are compounds that reduce or prevent flame propagation or increase the inflammability of a material. Examples of flame retardants include but are not limited to halogenated aromatic compounds, like halogenated biphenyls or biphenyl ethers and bisphenols. Typically the halogenated materials are brominated or polybrominated. Specific examples include bisphenols like polybrominated biphenyl, penta-, octa and deca deca-brominated diphenyl ethers (BDE's), tetrabromobisphenol-A (TBBPA).
Further examples include but are not limited to inorganic compounds like alumina trihydrate, antimony oxide, magnesium hydroxide, zinc borate, organic and inorganic phosphates, red phosphor and combinations thereof.

### Anti-Dripping Agents:

Anti-dripping agents are substances that reduce or prevent dripping of a polymer when being exposed to a flame. Typically, dripping agents include fluoropolymers, such a polytetrafluoroethene polymers and copolymers. The dripping agents may be dispersed in or blended with the polymer making up the respective layer. Commercial examples of dripping agents include MM5935EF from Dyneon LLC, ALGOFLON DF210 from Solvay-Solexis or ENTROPY TN3500 from Shanghai Entropy Chemical.

### Pigments, dyes and reflective materials:

Pigments may be inorganic or organic. Pigments may be of green, blue, red, pink, purple and white colour. Pigments are dispersed in the layer containing them contrary to dyes which are dissolved in the layer containing them. Most commonly used white pigments are inorganic pigments. Examples include but are not limited to zink oxides and titanium oxides (like TiO₂). The pigments may be dispersed, blended or dissolved (in which case the pigments are more appropriately referred to as dyes) in the layer or may be painted or printed onto a layer. White pigments are typically used to enhance the reflective properties of a layer of the backsheet.

Reflective materials include glass particles or metal particles, with glass particles being preferred. They may be dispersed, blended or dissolved in a layer.

### Carbon particles:

Carbon particles may be added to increase the weathering resistance of the backsheet. Carbon particles typically lead to the layer of the backsheet containing them having a black colour. Examples of carbon particles include but are not limited to graphite, fullerenes, nanotubes, soot, carbon blacks (e.g. carbon black, acetylene black, ketjen black). The carbon particles may be modified, for example surface treated, coated or may contain functionalised groups (e.g. by chemical reaction with chemical modifiers or by adsorption of chemicals). The amount of carbon particles should be limited to values that do not render the backsheet or the particular layer electronically conductive. Typically, a layer of the backsheet may contain from about 1% to about 6% or up to about 10% weight based on the weight of the layer of carbon particles.

### Additional layers:

The backsheet (13) is a multi-layer article. In addition to the bonding layer (14) the backsheets (13) according the invention contain at least one additional layer forming the rear side (111) of the backsheet. The at least one additional layer may contain one or more non-polyolefin sheets, for examples polyamides, polyester (e.g. polyterepthalates), copolymers of α-olefins with ethylenically unsatured carboxylic acids ((meth)acrylates), carboxylic acid esters ((meth)acrylic esters) and/or anhydrides. Further examples include copolymers of olefins and vinyl esters, like vinylacetates (e.g.EVA), fluoropolymers and polycarbonates. The additional layer(s) may be coextruded or laminated to the bonding layer (14). They may also be attached to the bonding layer (14) by using tie-layers or adhesives.

Preferably, the backsheet (13) contains the bonding layer (14) and the further bonding layer (100), although the back layer (100) may not be a further bonding layer but a non-polyolefin-based sheet. Preferably, the back layer (100) is a further bonding layer (100) and contains a polyolefin sheet (114) and forms the rear surface (111) of the backsheet (13). It is an advantage of the backsheets provided herewith that they can be constructed using one or more polyolefin sheets (114) or even using exclusively polyolefin sheets (114) which may be of similar or different composition or dimensions. It has been found that such polyolefin-based constructions are advantageous over multi-layer constructions containing polymers of different chemical classes. Because of their chemical compatibility the polyolefin-based sheets (114) can be coextruded and do not require adhesives or tie-layers.

Therefore, the backsheets (13) according to the present disclosure contain at least one polyolefin sheet (114) as bonding layer (14), and preferably a further polyolefin sheet (114) as a further bonding layer (100) for adhesion to an aluminium containing surface. Preferably, the bonding layer (14) and the further bonding layer (100) are separated by at least a third layer between them, like for example an intermediate layer (ii), for example layer (102) of figures 4 and 5. The backsheet (13) may further contain additional layers which may provide other or additional functions, for example optional layers (iv) and (v). Part of the external surface of the further bonding layer (100) may be covered by additional layers as long as the bonding layer retains external areas for bonding to an aluminium support structure.

### Intermediate layer (layer (ii)):

The intermediate layer separates the bonding layer (40) from the back layer (100). It may be optional and the backsheet may be a two layer article. The intermediate layer(s) may provide the greatest contribution to the electrical insulation of the backsheet (i.e. the layer may have the highest break down voltage of all layers of the backsheet if measured individually. Typically the layer (ii) may have a thickness of at least 150 mm, at least 210 µm or at least 310 µm or at least 350 µm.

The intermediate layer may comprise a polyolefin sheet (114) as described above or another polymer like for example a polyester or a polyamide. Preferably, the layer (ii) contains a polyolefin sheet (114) and may contain, for example, up to about 10 wt %, preferably up to about 5 wt %, and more preferably up to about 1 wt % of anitoxidants based on the total weight of the layer. In addition or instead of antioxidants the layer may contain, for example, up to about 10 wt %, preferably up to about 5 wt %, and more preferably up to about 1 wt % of UV-stabilizers based on the total weight of the layer.
In addition or instead of antioxidants and/or UV-stabilizers the layer (ii) may contain anti-dripping agents like those described below. Typical amounts include up to 1% wt, or up to %wt or up to 10% wt based on the weight of the layer.

Preferably, the layer (ii) does not contain carbon particles. Preferably, layer (ii) does not contain organic or inorganic pigments. Preferably, layer (ii) does not contain carbon particles and pigments. Thus, in one embodiment, layer (ii) is free of pigments as those described below. Preferably, layer (ii) is free of carbon particles or free of carbon particles and pigments. "Free of" as used herein means from 0 to less than 1% wt or from 0 to less than 0.1% wt or from 0 to less than 0.01% wt based on the weight of the layer or 0% (within the detection limit). Such layers may be transparent.

More preferably, layer (ii) does not contain any additives other than flame retardants and anti-oxidants as described below.

### Optional layers (iv), (v), (vi):

One or more optional layers may be introduced into the backsheet (13) to introduce further desirable properties or to enhance the existing properties.
For example coloured layers or layers containing patterns displaying decoration or information may be introduced to the backsheet by introducing optional layers (iv), for example between layers (14) and (ii), between layer (ii) and (100), or between (14) and (100). Such coloured layers may contain the polyolefins as described above and pigments or pattern displaying information or decoration printed thereon or introduced into the surface of that layer by surface-treatment.

To further reduce the vapour transmission rates a metal layer (v), for example a metal foil, like an aluminium foil, may be incorporated into the backsheet, for example between layers (ii) and (100) or (40) and (100). The thickness of this optional layer (v) may be in the range of 5 - 100 µm based on the type of material used.

In a specific embodiment the backsheet (13) contains an aluminium foil between two polyolefin-based layers (114). However, it is preferred that such polyolefin layers do not contain carbon particles. If a polyolefin-based layer (114) containing carbon particles is required it is preferably present as a separate layer. Samples containing an aluminium foil between two uncoloured LDPE or uncoloured or white HDPE showed adhesion to the aluminium foil that did not deteriorate after the pressure cooker test described below, while a construction with an aluminium foil between two black HDPE layer (i.e. carbon particle containing sheets (114)), showed a significant reduction of initial adhesion of 18 N/cm at the same pressure cooker test.

Another optional layer includes one or more external protection layers (vi) in case the back layer (100) is a further bonding layer containing a polyolefin sheet (114). The protection layer faces the back layer (100) on its one side and the environment on its opposite side. If incorporated it may be exposed to the environment from the non-light-receiving side of the solar module. This layer may comprise polyurethanes, polyacrylates, silicones, fluoropolymers and combinations thereof. It may contain additives which further increase the UV stability, thermal stability and resistance to oxidation or corrosion. It may contain flame retardants or it may provide anti-scratch properties or easy-to-clean properties. It may also be a coloured layer to provide the outside of the backsheet with another colour than black. In case optional external protection layers (vi) are present they are of smaller length and or width than the bonding layer (100) to ensure the further bonding layer (100) maintains an external surface for lamination to the support structure.

If materials other than polyolefin sheets (114) need to be bonded to the bonding layer (14) the surface energy of the polyolefin sheet (114) is preferably increased by appropriate surface modification methods (corona treatment and the like) to achieve the required adhesion. Alternative methods include the use of adhesives, primers or tie layers.

One or more scrim or net layers may also be present to further increase dimensional stability and handling properties. Scrim or net type layers may also improve the anti dripping performance during burning. Scrim or net layers may be net-shaped or otherwise discontinuous layers of non-woven or woven polymeric material or organic or inorganic fibers.

Another advantage of the present disclosure is that a backsheet (13) having some or all of the properties described herein may be prepared without requiring layers from other polymers than polyolefin-based materials. Therefore, the backsheets (13) provided herein may be free of one or more or of all of the following polymers or polymer layers: fluoropolymers, polyester, polyamides, polyterepthalates, polyacetates, like polyvinylacetates, or ethylvinylacetates, polycarbonates or polyacrylates and acrylic comonomers.

The backsheets (13) may also be free of tie-layers because polyolefin-based materials are compatible with each other and can be coextruded. Tie-layers are polymeric layers between two dissimilar polymers and binding the dissimilar polymer layers. Dissimilar polymer layers are layers of two different chemical classes. Typically, the two dissimilar polymers would not or only poorly bind to each other, without the tie-layer. Dissimilar polymers are polymers having the majority or repeating units derived from a different monomer, e.g. a polyamide versus a polyester. Examples of tie-layer polymers include polymers modified to contain functional groups like hydroxyl, epoxy, or amine, carboxylic acid groups or anhydride groups.

In a particular embodiment according to the present disclosure the backing sheet contains a bonding layer (14) and a further bonding layer (100) which contain a polyolefin sheet (114) as described herein. In this embodiment the backsheet may be longer/and or wider than the top part of the solar module and can be folded around the edge of the top part of the solar module.

In another embodiment the backsheet is an all polyolefin-based material and only contains layer of polyolefin sheets (114) as described above. For example, the backsheet may contain a top layer (i) (bonding layer (14)) containing HDPE (and optionally white pigments) and a rear layer (iii) (further bonding layer (100)) also containing HDPE and optionally carbon particles. It may additionally contain an intermediate layer (ii) containing, for example LDPE. All three layers are preferably coextruded, which means that layer (i) and (ii) and layer (ii) and (iii) form a continuous common interface. All layers have been subjected to a cross-linking treatment, preferably e-beam treatment, which means that the polymers of the individual layers are cross-linked. The layers (i), or layer (ii) and/or layer (iii) may additionally contain UV stabilisers and/or antioxidants. They may also contain flame retardants and/or anti-dripping agents. Layers (i) and/or (iii) may further contain antioxidants.

Specific embodiments of backsheets (13) according to the present disclosure are now further illustrated by referring to the figures 3 and 4, showing schematic representations of a cross-section of the backsheets (13). The backsheet (13) according to figure 3 contains a top layer (i), which is bonding layer (14) forming the top surface (131) of the backsheet (13). The bonding layer (14) contacts the carrier (124) of the semiconductors in the solar cell layer of the solar module (not shown). The backsheet (13) further contains an intermediate layer (ii) represented by (101) abutting the bonding layer (14) which makes up the entire top surface (131) of the backsheet and contains the polyolefin sheet (114). The backsheet shown in figure 3 has a length L' that may be greater than the length of the top part of the solar module, such that it can be folded by its extending end(s) around the top part of the solar module, in which case it contains a back layer (iii) that acts as a further bonding layer (100) containing the polyolefin sheet (114).

Figure 4 shows a similar backsheet which additionally contains layer (102), which is an optional layer as described herein, and preferably is a moisture barrier, like an aluminium foil.

The layers (100) and (101) of the backsheets shown in figures 3 and 4 may contain the polyolefin sheets (114) as described herein. For example, the top layer (14) bottom of figures 3 and 4 may contain white pigments and contains HDPE (114). Layer (100) may contain HDPE (114) and carbon black. The layer (101) may contain LDPE (114). All three layers may contain UV stabilisers and are preferably coextruded. This means the layers from a continuous common interface. All layers have been subjected to a cross-linking treatment, preferably e-beam treatment, which means that the polymers of the individual layers are cross-linked. The cross-linking treatment may be carried out by bulk cross-linking which means that also the neighbouring layers (i.e. layers (100) and (101) and (14) and (101) may be cross-linked with each other.

Figures 3 and 4 may also represent polypropylene backsheets in which case the individual layers contain polypropylene layers instead of poylethylene layers.

### Methods of making backsheets:

The backsheets (13) according to the present disclosure can be produced by any suitable process. Single layer materials can be prepared by combining the ingredients and extruding the composition. The compositions can generally be extruded at a temperature of about 130°C to 250°C or 160 °C to about 280°C. The extruder contains a die adapted to the thickness and width of the resulting backsheet.
For co-extrusion the compositions making up the layer are prepared by mixing the ingredients. The compositions are then extruded in molten form through the respective sheet-shaping dies. After extrusion, the back sheets (13) are cross-linked.

If desired, a surface of the encapsulant layer of the solar cell layer (12) facing the backing layer (13) may be treated prior to the lamination process to incorporate the backsheet to enhance the adhesion of the backsheet to the solar cell layer. This adhesion enhancing treatment may take any form known within the art and may include flame treatments, plasma treatments, electron beam treatments, oxidation treatments, corona treatments, chemical treatments, chromic acid treatments, hot air treatments, ozone treatments, ultraviolet light treatments, sand blast treatments, solvent treatments, and combinations of two or more thereof.

The backsheets provided herein can be satisfyingly bonded to the aluminium containing carrier material of the solar cells and additionally also to the encapsulant material, in particular when the encapsulant contains EVA or silicones. Bonding to carrier (and encapsulant) is generally achieved by lamination, in particular vacuum lamination. This way encapsulant material can be saved as the backsheet acts by laminating to the carrier material also as encapsulant.

### Method of making solar modules:

Solar modules may be prepared by stacking the component layers of the solar cell module in a desired order to form a pre-lamination assembly. The assembly may then be subjected to lamination simultaneously or subsequently. Lamination may be carried out under vacuum or by the application of pressure.

For example the assembly may be placed into a bag capable of sustaining a vacuum ("a vacuum bag"), the air is drawn out of the bag by a vacuum line or other means, the bag is sealed while the vacuum is maintained and the sealed bag is placed in an autoclave at a pressure and temperature sufficient to provide lamination. A vacuum ring may be substituted for the vacuum bag. Following the heat and pressure cycle, the air in the autoclave may be cooled without introducing additional gas to maintain pressure in the autoclave. The excess air pressure is vented and the laminates are removed from the autoclave.

The pre-lamination assembly may also be heated in an oven after which the heated assembly may be passed through nip rolls so that the air in the void spaces between the individual layers may be squeezed out, and the edge of the assembly sealed. The assembly at this stage is referred to as a pre-press. The pre-press may then be placed in an air autoclave subjected to an appropriate temperature and pressure regime to achieve laminated products.

The backsheets (13) can be laminated with their bonding layer (14) to the aluminium containing carrier (124) in the solar cell layer (12) by standard lamination procedures.

In embodiments where the backsheets contain a back layer (100) containing a polyolefin sheet (114) and acting as a further bonding layer the backsheets (13) may be laminated directly to a support structure by contacting the aluminium-containing surface with their further bonding layer (100).

The lamination typically involves temperatures between 140 and 200 °C. The backsheets may be subjected to a heat treatment, for example in an oven, and may be applied in hot form to the aluminium surface to which they are to bond. The hot backsheet is then pressed onto the surface to create a bond. Alternatively, the aluminium containing surface or both aluminium containing surface and backsheet may be subjected to the heat treatment for creating the bond.

The following list of exemplary embodiments illustrates various specific features, advantages, and other details of the invention. The particular materials and amounts recited in these exemplary embodiments, as well as other conditions and details, should not be construed in a manner that would limit the scope of this invention.

### List of embodiments:

1. Method for making a solar module (1) comprising in order of position from the front, i.e. the light-receiving side, to the back:
   (a) a top part (40) comprising a top layer (11) and a solar cell layer (12) containing at least one encapsulant (121) and solar cells (122) on an aluminium-containing carrier (124) and
   (b) a bottom part (41) comprising a multi-layer backsheet (13) contacting at least the aluminium containing carrier (124) of the solar cell layer (12), said method comprising
      i) providing a multi-layered backsheet (13) having at least one bonding layer (14) forming the top surface (131) and at least one layer forming the rear surface (111) opposite to the top surface (131) of the backsheet (13) and wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof;
      ii) laminating the backsheet with its bonding layer (14) to the carrier (124) of the solar cells (222) of the solar cell layer (12).
2. The method according to 1 wherein the polyolefin sheet (114) comprises a cross-linked polyethene homo polymer or cross-linked polyethene copolymers comprising repeating units derived from ethene and one or more α-olefinic hydrocarbons.
3. The method according to any one of 1 or 2 wherein the cross-linked polyethene homopolymer or copolymer has been cross-linked by e-beam treatment.
4. The method according to any one of the preceding embodiments wherein the polyethene copolymer contains more than 80% by mole and more preferably at least 95% by mole or more than 99% by mole of units derived from ethene.
5. The method according to any one of the preceding embodiments wherein the polyethene polymer is selected from linear low densitiy polyethenes (LLDPE), low density polyethenes (LDPE), medium density polyethenes (MDPE), high density polyethenes (HDPE), or a combination thereof.
6. The method according to any one of the preceding embodiments wherein the bonding layer (14) has a thickness of at least 0.250 mm.
7. The method according to any one of the preceding embodiments wherein the bonding layer (14) comprises a UV stabiliser.
8. The method according to any one of the preceding embodiments wherein the bonding layer (14) is not transparent and comprises white pigments or carbon particles.
9. The method according to any one of the preceding embodiments wherein the bonding layer (14) forms the entire top surface (131) of the backsheet (13).
10. The method according to any one of the preceding embodiments wherein the layer forming the rear surface (111) of backsheet (13) is also a bonding layer containing a polyolefin sheet (114), which may be identical or different to the bonding layer (14).
11. The method according to 10 further comprising laminating the solar module (1) to an aluminium containing support structure (2) by its rear surface (111).
12. The method according to 10 or 11 wherein the backsheet (13) has a length (L') and/or width that is greater than the length (L) and/or width of the top part (40) of the solar module (1) and can be wrapped around at least one edge of the top part (40).
13. The method according to any one of the preceding embodiments wherein the lamination is carried out at a temperature of greater than 140°C.
14. An aluminium containing support structure (2) for solar modules comprising a solar module (1) as defined in any one of 10 or 12 laminated to the support structure (2) by at least a part of the rear surface (111) of the backsheet (13).
15. A solar module (1) comprising in order of position from the front, i.e. the light-receiving side, to the back:
   (a) a top part (40) comprising a top layer (11) and a solar cell layer (12) containing at least one encapsulant (121) and solar cells (122) on an aluminium-containing carrier (124) and
   (b) a bottom part (41) comprising a multi-layer backsheet (13) having a bonding layer (14) forming the top surface (131) of the backsheet (13) and contacting at least the aluminium containing carrier (124) of the solar cells (122) of the solar cell layer (12), and at least one layer forming the rear surface (111) that is opposite to the top surface (131) and is exposed to the outside of the solar module, wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.
16. The solar module (1) according to 14 wherein the backsheet (13) is as defined in any one of embodiments 2 to 11.

### Examples:

### Materials:

- Hostavin N30: sterically hindered amine light stabiliser (HALS), UV stabilizer, Clariant GmbH, Gersthofen, Germany, used as polyethene masterbatch containing 20% wt. of HALS in LUPOLEN 3020K).
- Hostalen HD 9550 F: high density polyethylene (0,95 g/cm³) Lyondell Basell Industries Holdings B.V., Rotterdam, The Netherlands.
- Lupolen 3020 K: low density polyethylene (0,927 g/cm³), Lyondell Basell Industries Holdings B.V., Rotterdam, The Netherlands.
- Polybatch UV 1952: stabilizer masterbatch, containing 10 % wt. of a hindered amine light stabilizer, A.Schulman GmbH, Kerpen, Germany.
- Polywhite NG 8270 W: white masterbatch, containing 60% wt. titanium dioxide (rutile) in polyethylene, A.Schulman GmbH, Kerpen, Germany.
- Polyblack 1423,: black masterbatch, containing 40% wt. carbon black in polyethylene, A.Schulman GmbH, Kerpen, Germany.
- Polybatch PR 1049 DC: masterbatch containing flame retardants (halogenated organics), A. Schulman, Kerpen, Germany.

### Methods:

### Dielectric breakdown voltage:

The dielectric breakdown voltage was determined according to ASTM D149, method A. The tests were carried on with type 2 electrodes and a voltage rate-of-rise of 500V/sec in a Hypotronics Type 970 dielectric breakdown strength tester. The tests were done in oil.

### Tensile strength:

The tensile strength and elongation at break were determined according to ASTM D-882 on a tensile tester, commercially available from Zwick, Germany with a 500 N load cell and a test speed of 100 mm/min.

### Pressure cooker test:

The samples were subjected to a pressure cooker test (DIN EN 60749-33) to test their endurance under wet heat conditions. The samples were placed on an aluminium tray in an oven. The aluminium tray was placed above the water reservoir (tap water) generating the steam. Test conditions were 121 °C at 1 bar pressure for 100 hours

### Example 1

A three layer polyethylene backsheet was prepared by first preparing the compositions for the individual layers. The top layer composition (layer (i)) was prepared by blending 2,000 g of Polywhite NG 8270 W with 7,500 g of Hostalen HD 9550 F and with 500 g of Polybatch UV 1952 in a tumble mixer at room temperature.

The composition for the bonding layer (14) which in this embodiment is also the back layer (layer iii) of the backsheet was prepared by blending 1,000 g of Polyblack 1423 with 8,500 g Hostalen HD 9550 F and with 500 g of Polybatch UV 1952 in a tumble mixer at room temperature.

The composition of the middle layer (layer (ii) was prepared by blending 9,500 g Lupolen 3020K with 500 g of Polybatch UV 1952 in a tumble mixer at room temperature.
To produce three-layered coextruded samples a coating line with 3 extruders was used. The white (solar facing) layer (i) was metered by a KTron Gravimetric Feeder, commercially available from KTron, Germany, into a twin screw extruder, commercially available from Werner & Pfleiderer, Germany, with a screw diameter of 25 mm and a length of 45 times the screw diameter. The middle layer (ii) was melted with a single screw extruder commercially available from Plastik Maschinenbau, Germany with a screw diameter of 45 mm and a length of 30 times the screw diameter. The black (backside facing) layer (iii) was melted with a single screw extruder commercially available from Extrudex, USA with a screw diameter of 30 mm and a length of 30 times the screw diameter.

All 3 extruders fed the polymers into a Cloeren 3-layer-feed block to feed the molten stream into the positions i-ii-iii in the final melt stream. The melt stream was fed through a slot die, commercially available from EDI. The coextruded examples were made while casting from a slot die directly between a chilled stainless steel roll and a rubber roll without significant draw. The cooled layers were wound into a roll.

After extrusion the three-layer product was subjected to e-beam radiation to cross-link the material using an e-beam unit commercially available from Polymer Physics, using 295 kV with a beam current of 4 mA at a line speed of 3m/min and beam width of 30 cm. The samples were treated 4 times. A 50 cm x 20 cm wide sample was cut from the sheet for further testing.

The material of example 1 was compared with other materials:
C1: A backsheet containing polyamide layers (Icosolar AAA 3554, Isovolta AG, Wiener Neudorf, Austria);
C2: A backsheet comprising a PET/PET/EVA composition (DYMAT PYE, Coveme, San Lazzaro di Savena, Italy);
C3: A backsheet containing a PVF/PET/PVF composition (Icosolar 2442, Isolvolta AG); C4: A backsheet containing a PVF/PET/PVF composition (AKASOL PTL 3HR 700V, Krempel, Vaihingen/Enz, Germany).

The materials were subjected to a pressure cooker test DIN EN 60749-33 to test their hydrolytic stability and ageing properties. The mechanical and electrical properties of the materials were tested before and after the pressure cooker test.

**Table 1: properties before pressure cooker test**

| | C1 | C2 | C3 | C4 | Ex 1 |
|---|---|---|---|---|---|
| Thickness [µm] | 370 | 300 | 300 | 370 | 450 |
| Dielectric Breakdown Voltage [kV] | 18.5 | 21.3 | 22.0 | 22.4 | 22.9 |
| Tensile [MPa] | 28.1 | 87.0 | 91.8 | 97.0 | 29.3 |
| Elongation at break [%] | 270.0 | 77.9 | 96.7 | 98.5 | 328.2 |

**Table 2: properties after pressure cooker test and degree of deterioration (reduction in original properties).**

| | C1 | C2 | C3 | C4 | Ex 1 |
|---|---|---|---|---|---|
| Appearance | Intact | Complete delamination | intact | Partial delamination | Intact |
| Reduction in Dielectric Breakdown | 0% | - | ca 5% | ca 10% | 0% |
| Tensile [MPa] | 26.7 | - | 12.7 | 5.5 | 24.1 |
| (Reduction) | (5%) | | (86%) | (94%) | (18%) |
| Elongation at break [%] | 30.3 | - | 18.1 | <1 | 295.0 |
| (Reduction) | (89%) | | (81%) | (99%) | (10%) |

### Examples 2 to 4:

Example 1 was repeated but using various amounts of flame retardant (Polybatch PR 1049 DC).
In example 2 the flame retardant was added to layer (ii) by 15 % by weight. The resulting backsheet had a break down voltage of 23.18 kV.
In example 3 the flame retardant was added to layer (ii) by 30% by weight. The resuting backsheet had a break down voltage of 23.64 kV.
In example 4 example 3 was repeated by also adding the flame retardant by 30% by weight to layer (iii). The resulting backsheet had a breakdown voltage of 24.80 kV.

### Example 5:

A three layer backsheet was prepared as described in example 1 with the following differences:
layer (i): 250 g HOSTAVIN N30 masterbatch (20% wt of HOSTAVIN N30) were used instead of POLYBATCH UV 1952. The amount of Hostalen used was 7,750 g.
layer (ii): 250 g HOSTAVIN N30 masterbatch were used instead of POLYBATCH UV 1952. The amount of LUPOLEN used was 9,750 g.
layer (iii) ( = bonding layer (14): 250 g HOSTAVIN N30 masterbatch were used instead of POLYBATCH UV 1952. The amount of HOSTALEN was 9,250 g.

The backsheet was subjected to a damp heat test and placed into a humidity chamber at 80% r.h. and 85 °C for 2,000 hours and tested for colour degradation of the white front side by determining the Yellowness index according to ASTM E313-1. The index increased moderately from -5.8 to -3.2 after 2,000h treatment.

### Example 6:

The backsheet of example 5 was subjected to a cycled UV- exposure. The backside (layer (iii)) was irradiated with UV light (340 nm), 1.3 W/m² nm for 12 hour interval at 75°C, then the UV irradiation was stopped for 4 hours. The cycle was repeated for the time intervals indicated below. The dielectric breakdown, tensile strength and elongation at break of the backsheet material were determined as described above. The electric breakdown voltage remained between 23 and 24 kV after exposure for 500 h, 1,000 h and 1,500 h. The breakdown voltage slightly increased to values 25 and 27 kV after exposure for 2,000 h and 3,000 h, respectively. The elongation at break remained between 330% and 350% after exposure to 500 h, 1000 h, 2000 h and 3000 h. The yield strength (tensile) decreased from 28 MPa to 27 MPa after exposure of 3000h.

### Example 7 and comparative example C7:

The backsheet of example 5 was subjected to oven storage at various temperatures. The yield strength (tensile) of the backsheet was determined at various time intervals (437 and 1175 hours, and compared to the initial value and the reduction of the initial value was calculated (example 7). The test was repeated with Melinex D 243 from DuPont Teijin, Luxembourg, Luxemburg, which is a 50 µm thick UV and hydrolysis resistant polyester film for backsheets of solar modules (comparative example C7).
After exposure to 140°C for 1175 hours, the tensile strength of the backsheet according to example 7 was reduced by less than 10%. The tensile strength of C7 was reduced by about 20%. After heat treatment at 170°C the tensile strength of example 7 was reduced by about 35% compared to a reduction of about 65% for C7.

### Example 8: theoretical example for making a PP backsheet:

A three layer polypropene backsheet may be prepared by first preparing the compositions for the individual layers. The top layer composition (layer (i)) may be prepared by blending 2,000 g of Polypropene masterbatch containing 10% white pigments, 7,500 g polypropene and with 500 g of PP masterbatch comprising 10% wt of UV stabiliser (HALS) in a tumble mixer at room temperature.

The composition for the back layer (layer iii) = bonding layer (14)) can be prepared by blending 1,000 g of a PP masterbatch containing 10% carbon black with 8,500 g propylene and with 500 g of a PP masterbatch containing 10% UV stabiliser (HALS) in a tumble mixer at room temperature.

The composition of the middle layer (layer (ii) may be prepared by blending 9,500 g polypropene with 500 g of PP masterbatch containing 10% UV stabiliser (HALS) in a tumble mixer at room temperature.

To produce three-layered coextruded samples a coating line with 3 extruders may be used. The white (solar facing) layer (i) may be metered by a KTron Gravimetric Feeder, commercially available from KTron, Germany, into a twin screw extruder, commercially available from Werner & Pfleiderer, Germany, with a screw diameter of 25 mm and a length of 45 times the screw diameter. The middle layer (ii) may be metered with a single screw extruder commercially available from Plastik Maschinenbau, Germany with a screw diameter of 45 mm and a length of 30 times the screw diameter. The black (backside facing) layer (iii) may be metered with a single screw extruder commercially available from Extrudex, USA with a screw diameter of 30 mm and a length of 30 times the screw diameter.

All 3 extruders may fed the polymers into a Cloeren 3-layer-feed block to feed the molten stream into the positions i-ii-iii in the final melt stream. The melt stream may be fed through a slot die, commercially available from EDI. The coextruded examples may be made while casting from a slot die directly onto a chilled stainless steel roll without significant draw. The cooled layers may be wound into a roll.

After extrusion the three-layer product may be subjected to e-beam radiation to cross-link the material using an e-beam unit commercially available from Polymer Physics, using a treatment as described above.

### Examples 9 and 10:

Examples 9 and 10 demonstrate the adhesion of the cross-linked polyolefin sheets to aluminium surfaces.

### Example 9:

The three layer polyethylene backsheet from example 1 was subjected to a corona treatment (nitrogen atmosphere; energy density of 1 J/cm²) and laminated in a vacuum laminator at 160°C and 9 minutes onto aluminum plates with a pressure of 1 bar. The peel force before weathering (pressure cooker test) was 18 N/cm as determined on a Zwick-Roell Z020 pull machine. An equivalent sample was tested in a pressure cooker test at 130°C and 2.8 bar water vapor pressure for 120 h. The peel force after weathering did not significantly change and was determined to be 17 N/cm. This test shows that the adhesion of the cross-linked polyolefin layer to the aluminium did not get reduced upon prolonged exposure to humid heat.

### Example 10:

A solar module prototype (mini module) with a size of 10 x15 cm (W x L) was prepared by vacuum lamination with the following set-up: 4 mm thick glass sheet, 2 layers of 0.48 mm thick EVA layers and one layer of the polyethylene backsheet of example 1. The assembly was laminated at 160°C for 9 minutes (vaccum lamination, lamination pressure 1 bar). The polyethylene film was about 1 cm longer on each side than the glass sheet. The extending part of the polyethene film was wrapped around the edge of the glass sheet. An aluminum frame was preheated to 160°C on a hot plate. The aluminium frame had an opening for receiving the mini module of a width of 5mm. The mini module was pressed by its wrapped edge into the opening of the heated frame. After cooling to room temperature the adhesion of the module to the frame was so strong that that the mini module could not be removed from the frame by hand.

## Claims

1. Method for making a solar module (1) comprising in order of position from the front, i.e. the light-receiving side, to the back:
(a) a top part (40) comprising a top layer (11) and a solar cell layer (12) containing at least one encapsulant (121) and solar cells (122) on an aluminium-containing carrier (124) and
(b) a bottom part (41) comprising a multi-layer backsheet (13) contacting at least the aluminium containing carrier (124) of the solar cell layer (12), said method comprising
i) providing a multi-layered backsheet (13) having at least one bonding layer (14) forming the top surface (131) and at least one layer forming the rear surface (111) opposite to the top surface (131) of the backsheet (13) and wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof;
ii) laminating the backsheet with its bonding layer (14) to the carrier (124) of the solar cells (222) of the solar cell layer (12).

2. The method according to claim 1 wherein the polyolefin sheet (114) comprises a cross-linked polyethene homo polymer or cross-linked polyethene copolymers comprising repeating units derived from ethene and one or more α-olefinic hydrocarbons.

3. The method according to any one of claims 1 or 2 wherein the cross-linked polyethene homopolymer or copolymer has been cross-linked by e-beam treatment.

4. The method according to any one of the preceding claims wherein the polyethene copolymer contains more than 80% by mole and more preferably at least 95% by mole or more than 99% by mole of units derived from ethene.

5. The method according to any one of the preceding claims wherein the polyethene polymer is selected from linear low densitiy polyethenes (LLDPE), low density polyethenes (LDPE), medium density polyethenes (MDPE), high density polyethenes (HDPE), or a combination thereof.

6. The method according to any one of the preceding claims wherein the bonding layer (14) has a thickness of at least 0.250 mm.

7. The method according to any one of the preceding claims wherein the bonding layer (14) comprises a UV stabiliser.

8. The method according to any one of the preceding claims wherein the bonding layer (14) is not transparent and comprises white pigments or carbon particles.

9. The method according to any one of the preceding claims wherein the bonding layer (14) forms the entire top surface (131) of the backsheet (13).

10. The method according to any one of the preceding claims wherein the layer forming the rear surface (111) of backsheet (13) is also a bonding layer containing a polyolefin sheet (114), which may be identical or different to the bonding layer (14).

11. The method according to claim 10 further comprising laminating the solar module (1) to an aluminium containing support structure (2) by its rear surface (111).

12. The method according to claims 10 or 11 wherein the backsheet (13) has a length (L') and/or width that is greater than the length (L) and/or width of the top part (40) of the solar module (1) and can be wrapped around at least one edge of the top part (40).

13. The method according to any one of the preceding claims wherein the lamination is carried out at a temperature of greater than 140°C.

14. An aluminium containing support structure (2) for solar modules comprising a solar module (1) as defined in any one of claims 10 or 12 laminated to the support structure (2) by at least a part of the rear surface (111) of the backsheet (13).

15. A solar module (1) comprising in order of position from the front, i.e. the light-receiving side, to the back:
(a) a top part (40) comprising a top layer (11) and a solar cell layer (12) containing at least one encapsulant (121) and solar cells (122) on an aluminium-containing carrier (124) and
(b) a bottom part (41) comprising a multi-layer backsheet (13) having a bonding layer (14) forming the top surface (131) of the backsheet (13) and contacting at least the aluminium containing carrier (124) of the solar cells (122) of the solar cell layer (12), and at least one layer forming the rear surface (111) that is opposite to the top surface (131) and is exposed to the outside of the solar module, wherein the bonding layer (14) comprises a polyolefin sheet (114) containing as its major component a cross-linked polymer selected from polyethene homo polymers, polypropene homopolymers, polyethene copolymers comprising repeating units derived from ethene and one or more α-olefinic hydrocarbons, polypropene copolymers comprising repeating units derived from propene and one or more α-olefinic hydrocarbons and combinations thereof.

16. The solar module (1) according to claim 15 wherein the backsheet (13) is as defined in any one of claims 2 to 11.
